**Europäisches Patentamt**

**European Patent Office**

**Office européen des brevets**

(19)

(11) Veröffentlichungsnummer: **0 075 071**
A2

# (12) EUROPÄISCHE PATENTANMELDUNG

(21) Anmeldenummer: 82104548.1

(22) Anmeldetag: **25.05.82**

(51) Int. Cl.³: **H 03 C 3/06**

(30) Priorität: **23.09.81 DE 3137843**

(43) Veröffentlichungstag der Anmeldung: **30.03.83**
**Patentblatt 83/13**

(84) Benannte Vertragsstaaten: **AT DE FR GB IT NL**

(71) Anmelder: **ROBERT BOSCH GMBH, Postfach 50, D-7000 Stuttgart 1 (DE)**

(72) Erfinder: **Hansen, Jens, Dipl.-Ing., Bülowstrasse 45, D-1000 Berlin 30 (DE)**

(74) Vertreter: **Schmidt, Hans-Ekhardt, Robert Bosch GmbH Geschäftsbereich Elektronik Patent- und Lizenzabteilung Forckenbeckstrasse 9-13, D-1000 Berlin 33 (DE)**

(54) **Filter- und Demodulationsschaltung.**

(57) Es wird eine Filter- und Demodulationsschaltung (11) vorgeschlagen, deren Nachsteuerungsverzögerungszeit möglichst gering sein soll. Die Schaltung umfaßt eine Filterkette aus mehreren in Reihe geschalteten breitbandigen Einzelfiltern (12, 13, 14), an die sich ein Demodulator (15) anschließt. Der Ausgang des Demodulators steht über eine Anpaßschaltung (18) mit je einem weiteren Eingang (20, 21, 22) der Einzelfilter in Verbindung. Die Anpaßschaltung liefert die Nachsteuerspannung zum Nachsteuern der Resonanzfrequenz der Einzelfilter. Durch die Verwendung von mehreren breitbandigen Einzelfiltern wird der Nachführbereich verbreitert und die Nachsteuerungsverzögerungszeit verringert.

19/81
EK/PLI Scht/Li
22. 9. 1981


ROBERT BOSCH GMBH, 7OOO Stuttgart 1


Filter- und Demodulationsschaltung


## Stand der Technik

Die Erfindung geht von einer Filter- und Demodulationsschaltung nach der Gattung des Hauptanspruchs aus.

Es ist eine Filter- und Demodulationsschaltung für
FM-Empfänger vorgeschlagen worden, bei der von der Ausgangsspannung des Demodulators eine Nachsteuerspannung
abgeleitet wird, die die Resonanzfrequenz eines dem
Demodulator vorgeschalteten schmalbandigen ZF-Filters
derart verschiebt, daß der Momentanwert der Zwischenfrequenz stets innerhalb des Durchlaßbereiches des
Filters liegt. Ein derartiges Filter hat den Nachteil,
daß durch die Nachsteuerungsverzögerungszeit, die der
Gruppenlaufzeit des Filters entspricht, der Breite des
Nachsteuerungs- bzw. Nachführbereiches eine mit den bisherigen Mitteln nicht überschreitbare Grenze gesetzt
ist bzw. daß bei einem gegebenen Nachführbereich keine
Erhöhung der Empfindlichkeit der Filterschaltung möglich ist.


## Vorteile der Erfindung

Die erfindungsgemäße Filter- und Demodulationsschaltung
mit den kennzeichnenden Merkmalen des Hauptanspruchs
hat den Vorteil, daß bei Verwendung einer Filterkette
aus mehreren verhältnismäßig breitbandigen Einzelfiltern
der Nachführbereich verbreitert bzw. bei gegebenem Nachführbereich die Empfindlichkeit der Filterschaltung
erhöht wird.

Durch die in den Unteransprüchen aufgeführten Maßnahmen sind vorteilhafte Weiterbildungen und Verbesserungen der im Hauptanspruch angegebenen Filter- und Demodulationsschaltung möglich. Besonders vorteilhaft ist eine Filter- und Demodulationsschaltung, bei der die Einzelfilter in steigender Reihenfolge derart schmalbandiger sind, daß der ZF-Durchlaßpunkt auf der Filterkurve den Grad der Schmalbandigkeit des jeweiligen Einzelfilters bestimmt, wobei der ZF-Durchlaßpunkt innerhalb des Durchlaßbereiches des betreffenden Filters liegt. Dadurch erhält man eine bessere Selektion der Zwischenfrequenz bei gleicher wirksamer Gruppenlaufzeit.

Zeichnung

Ausführungsbeispiele der Erfindung sind in der Zeichnung an Hand mehrerer Figuren dargestellt und in der nachfolgenden Beschreibung näher erläutert. Die Zeichnung zeigt in

Fig. 1    ein Blockschaltbild einer erfindungsgemäßen Filter- und Demodulationsschaltung in einer ersten Ausführungsform,

Fig. 2    je eine Filterkurve von drei Einzelfiltern
A ... D   sowie eine Gesamtfilterkurve für eine Schaltung nach Fig. 1,

Fig. 3    ein Prinzipschaltbild eines Einzelfilters,

Fig. 4    ein Blockschaltbild einer erfindungsgemäßen Filter- und Demodulationsschaltung in einer zweiten Ausführungsform und

Fig. 5    je eine Filterkurve sowie eine Gesamtfilter-
A ... D   kurve für eine Filter- und Demodulationsschaltung in einer dritten Ausführungsform.

Beschreibung der Ausführungsbeispiele

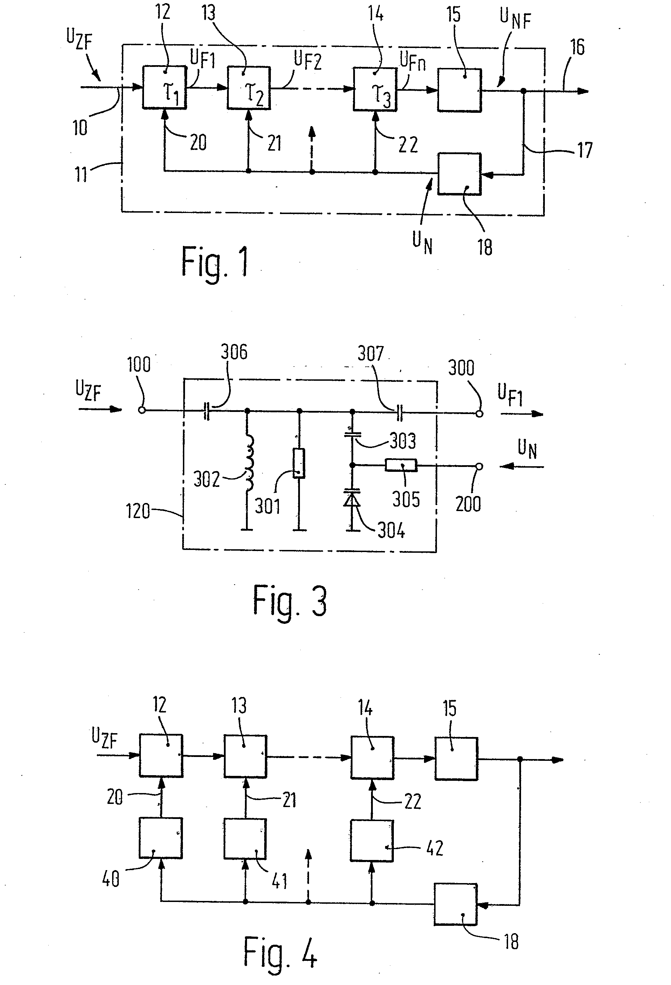

In Fig. 1 bezeichnet 10 einen zum Zuführen einer ZF-Spannung $U_{ZF}$ bestimmten Eingang einer erfindungsgemäßen Filter- und Demodulationsschaltung 11, die eine Reihenschaltung von drei Einzelfiltern 12, 13, 14 aufweist. Die durch eine gestrichelte Linie angedeutete Leitungsverbindung zwischen den Einzelfiltern 13 und 14 bedeutet, daß mehr als drei Einzelfilter, allgemein also n Einzelfilter, vorgesehen sein können. An das letzte Einzelfilter 14 schließt sich ein FM-Demodulator 15 bekannter Ausführung an, dessen eine Modulationsspannung $U_{NF}$ abgebender Ausgang den Ausgang 16 der Filter- und Demodulationsschaltung 11 bildet. Von dem Ausgang 16 zweigt eine Leitung 17 ab, die über eine Anpaßschaltung 18 an je einen weiteren Eingang 20, 21, 22 der Einzelfilter führt.

Die erfindungsgemäße Filter- und Demodualtionsschaltung nach Fig. 1 arbeitet folgendermaßen.

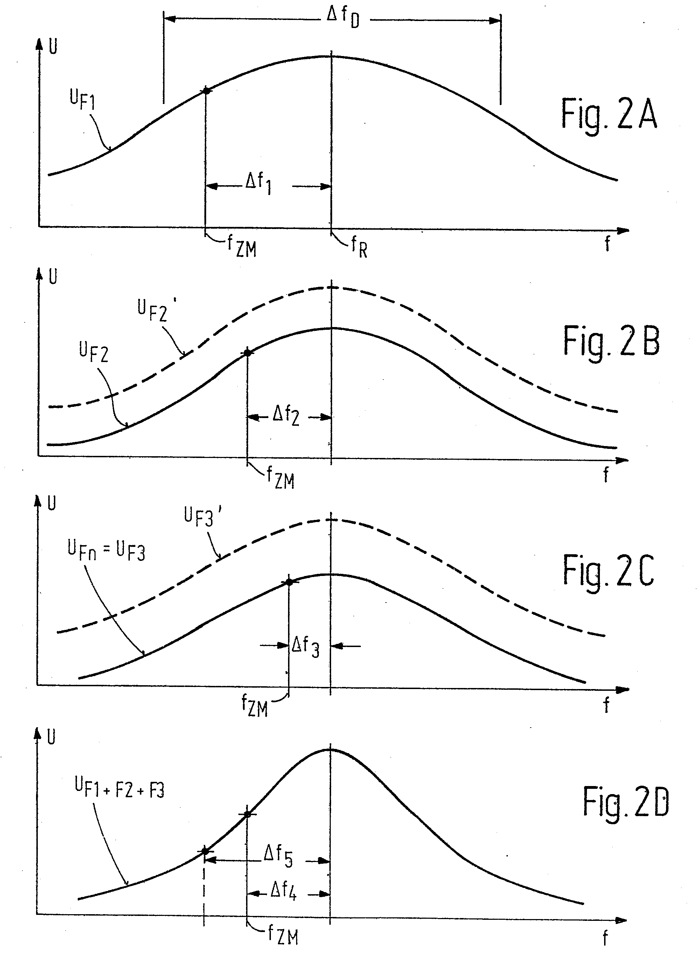

Die an dem Eingang 10 liegende ZF-Spannung $U_{ZF}$ passiert der Reihe nach die Einzelfilter 12, 13, 14. Als Einzelfilter finden Filter Verwendung, die gemäß den Fig. 2 A bis 2 C gleiche Filterkurven aufweisen, verhältnismäßig breitbandig sind und mittels einer an ihren weiteren Eingängen 20, 21, 22 liegenden gemeinsamen Nachsteuerspannung $U_N$ derart gesteuert werden, daß die jeweilige Momentan-Zwischenfrequenz $f_{ZM}$ im Durchlaßbereich $\Delta f_D$ des Einzelfilters liegt; vgl. Fig. 2 A bis 2 D.

Beim Passieren der Einzelfilter wird die ZF-Spannung $U_{ZF}$ um einen bestimmten Wert abgesenkt, so daß Filterkurven $U_{F2}$, $U_{F3}$ (vgl. Fig. 2 B, 2 C) entstehen, die parallel zu den ursprünglichen Filterkurven $U_{F2}'$ und $U_{F3}'$ in Richtung auf die Abszisse verschoben sind.

Die am Ausgang des letzten Einzelfilters 14 liegende Filterspannung $U_{Fn}$ wird dem Demodulator 15 zugeführt, an dessen Ausgang 16 die Modulationsspannung $U_{NF}$ zur weiteren Aufbereitung und Wiedergabe zur Verfügung steht.

Mit dem Anpassungsnetzwerk 18 wird aus der Modulationsspannung $U_{NF}$ die zum Nachsteuern der Einzelfilter dienende Nachsteuerspannung $U_N$ bereitgestellt. Der Wert der Nachsteuerspannung $U_N$ hängt von der jeweiligen Momentan-Zwischenfrequenz bzw. vom Momentanwert der Modulationsspannung $U_{NF}$ ab.

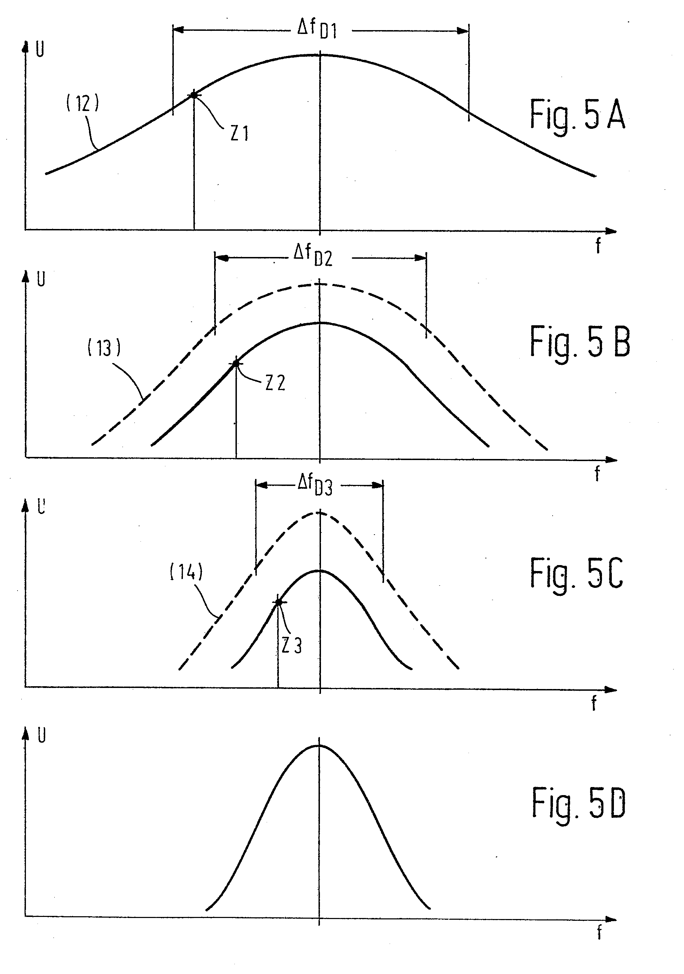

In Fig. 3 ist ein lediglich als Beispiel gedachtes Prinzipschaltbild eines Einzelfilters 120 gezeigt, das einem der Einzelfilter 12 bis 14 in Fig. 1 entsprechen kann. Das Einzelfilter 120 hat einen Eingang 100 für die ZF-Spannung $U_{ZF}$, einen weiteren Eingang 200 für die Nachsteuerspannung $U_N$ und einen Ausgang 300. Das Einzelfilter 120 ist ein durch einen Widerstand 301 bedämpfter LC-Parallelresonanzkreis mit einer Spule 302 und einem Kondensator 303, dem eine anodenseitig mit Masse verbundene Kapazitätsdiode 304 in Reihe geschaltet ist. Die Nachsteuerspannung $U_N$ wird der Kathode der Kapazitätsdiode 304 über einen Widerstand 305 zugeführt. Mit 306 und 307 sind Kondensatoren zur Entkopplung bezeichnet.

Durch die gleich großen Gruppenlaufzeiten $\tau_1$, $\tau_2$, $\tau_3$ der Einzelfilter 12, 13, 14 bedingt, ergeben sich für die einzelnen Filter verschieden große Nachsteuerungsverzögerungszeiten, die Frequenzabweichungen $\Delta f_1$, $\Delta f_2$, $\Delta f_3$ der Momentan-ZF $f_{ZM}$ gegenüber der zunächst für alle Einzelfilter gleichen Resonanzfrequenz $f_R$ zur Folge haben.

Die Fig. 2 A bis 2 C zeigen deutlich, daß sich die Frequenzabweichungen $\Delta f_1$ ... mit zunehmender Ordnungszahl der Einzelfilter verringern. Nur bei dem ersten Einzelfilter 12 ist die Nachsteuerung um die Gesamtgruppenlaufzeit $\tau = \tau_1 + \tau_2 + \tau_3$ verzögert, so daß sich nur in diesem Fall die maximale Frequenzabweichung $\Delta f_1$ ergibt.

In der Gesamtfilterkurve $U_{F1+F2+F3}$ nach Fig. 2 D ist links neben der Momentan-Zwischenfrequenz $f_{ZM}$ durch eine gestrichelte Linie angedeutet, welche Lage die Momentan-ZF einnähme, wenn anstelle der Filterkette aus den drei breitbandigen Einzelfiltern 12, 13, 14 ein einziges schmalbandiges Filter mit der gleichen Filtercharakteristik wie die der Filterkette eingesetzt würde. Es ist deutlich zu erkennen, daß die Frequenzabweichung $\Delta f_4$ bei einer Filterkette erheblich geringer ist als die Frequenzabweichung $\Delta f_5$ bei einem schmalbandigen Filter.

In Fig. 4, in der ein Blockschaltbild einer Schaltungsvariante zu dem Ausführungsbeispiel nach Fig. 1 gezeigt ist, werden für gleiche Baueinheiten gleiche Bezugszahlen wie in Fig. 1 verwendet. In Ergänzung zu der Filter- und Demodulationsschaltung 11 in Fig. 1 liegt zwischen dem Ausgang der Anpassungsschaltung 18 und den weiteren Eingängen 20, 21, 22 der Einzelfilter je ein NF-Filter 40, 41, 42. Die NF-Filter weisen verschiedene Filterkurven auf, die von dem Frequenzbereich der Modulationsspannung $U_{NF}$ und/oder der Amplitude der Modulationsspannung abhängen. Durch eine bestimmte Dimensionierung der einzelnen NF-Filter, die in bezug auf die Nachsteuerspannung $U_N$ eine voreilende Charakteristik haben, wird der Nachsteuerungsverzögerung entgegengewirkt.

Nach Fig. 5 A bis 5 D werden gemäß einer weiteren Variante der Filter- und Demodulationsschaltung 11 (vgl. Fig. 1) die Einzelfilter 12, 13, 14 mit zunehmender Ordnungszahl derart schmalbandig, daß der ZF-Durchlaßpunkt Z1, Z2, Z3 der Filterkurven (Fig. 5 A bis 5 C) den Grad der Schmalbandigkeit bestimmt. Dabei muß der ZF-Durchlaßpunkt innerhalb des Durchlaßbereichs $\Delta f_{D1}$, $\Delta f_{D2}$, $\Delta f_{D3}$ der Einzelfilter liegen.

0075071

19/81
EK/PLI Scht/Li
22. 9. 1981

ROBERT BOSCH GMBH, 7000 Stuttgart 1

Ansprüche

1. Filter- und Demodulationsschaltung für die Zwischenfrequenz
eines frequenzmodulierten Trägers mit einem schmalbandigen
Filter zum Ausfiltern des ZF-Signals und einem dem Filter
nachgeschalteten Demodulator, von dessen Ausgangsspannung
über ein Anpaßnetzwerk eine Spannung zum Nachsteuern der
Resonanzfrequenz des Filters abgeleitet wird, derart, daß
die Momentan-ZF stets im Durchlaßbereich des Filters liegt,
dadurch gekennzeichnet, daß anstelle des schmalbandigen
Filters eine Filterkette aus n breitbandigen und durch die
Nachsteuerspannung parallel nachsteuerbaren Einzelfiltern
(12, 13, 14) vorgesehen ist.

2. Filter- und Demodulationsschaltung nach Anspruch 1, dadurch
gekennzeichnet, daß die Einzelfilter (12, 13, 14) gleiche
Filterkurven aufweisen.

3. Filter- und Demodulationsschaltung nach Anspruch 1, dadurch
gekennzeichnet, daß die Einzelfilter (12, 13, 14) mit zunehmender Ordnungszahl derart schmalbandiger sind, daß der
ZF-Durchlaßpunkt (Z1) auf der Filterkurve den Grad der
Schmalbandigkeit des jeweiligen Einzelfilters (12) bestimmt,
wobei der ZF-Durchlaßpunkt innerhalb des Durchlaßbereichs
($\Delta f_D$) des betreffenden Filters liegt.

4. Filter- und Demodulationsschaltung nach Anspruch 1 oder 2,
dadurch gekennzeichnet, daß die Nachsteuerspannung ($U_N$) für
die Einzelfilter (12, 13, 14) über je ein NF-Filter (40,
41, 42) zugeführt wird, dessen Charakteristik vom Frequenzbereich und/oder von der Amplitude der Modulationsspannung
($U_{NF}$) abhängt.

Fig. 1

Fig. 3

Fig. 4

Fig. 2A

Fig. 2B

Fig. 2C

Fig. 2D

0075071

$\Delta f_{D1}$

U

(12)

Z1

f

Fig. 5 A

$\Delta f_{D2}$

U

(13)

Z2

f

Fig. 5 B

$\Delta f_{D3}$

U

(14)

Z3

f

Fig. 5 C

U

f

Fig. 5 D